# EUROPEAN PATENT APPLICATION

(11) **EP 4 723 828 A1**
(43) Date of publication of application: **08.04.2026**
(21) Application number: 25206972.9
(22) Date of filing: 06.10.2025
(51) Int. Cl.: H10D 30/00, H10D 30/69, H10D 30/65, H10D 62/10, H10D 62/13, B82Y 10/00

(54) **SEMICONDUCTOR DEVICES WITH MIXED CHANNEL**

(30) Priority: 07.10.2024 US 202418907691
(71) Applicant: Avago Technologies International Sales Pte. Limited, Singapore 768923 (SG)
(72) Inventor: Liu, Qing, Irvine, 92602 (US)
(74) Representative: Dilg, Haeusler, Schindelmann Patentanwaltsgesellschaft mbH

(57) **Abstract**

A semiconductor device with a mixed channel that is suitable for operability under high operating voltages (e.g., 2.5 volts to 3.3 volts). The semiconductor device includes a drain; a source; a channel comprising a first nanosheet and a second nanosheet; sacrificial layer disposed between the first nanosheet and the second nanosheet; and a gate formed around the channel.

## Description

### BACKGROUND

The present disclosure relates, in general, to semiconductor fabrication technology. More particularly, the present disclosure relates to semiconductor device structures that can be used to provide a more diverse range of operating voltages for implementations of gate-all-around field-effect transistor (GAAFET) devices and other similar devices. For example, the semiconductor device structures described herein can be used in various implementations of laterally diffused metal-oxide-semiconductors (LDMOS) for use in a variety of different high-power applications such as power amplifiers, radio frequency (RF) amplifiers, and power transistors for radio and wireless communication systems. As the demand for high-power applications increases, research and development efforts continue to advance semiconductor technologies to meet manufacturing capabilities and capacities of foundries and enhance the functionality of various electronic devices and circuits.

### BRIEF DESCRIPTION OF THE DRAWINGS

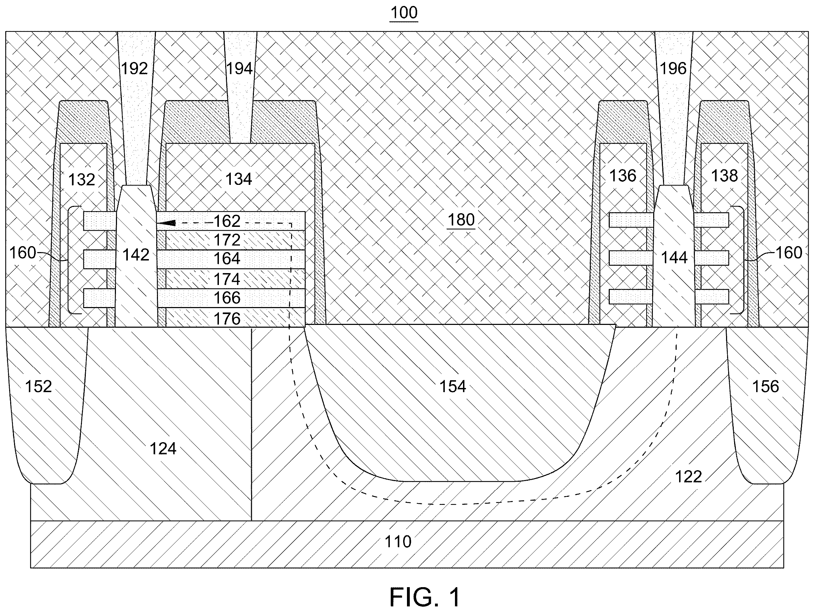

FIG. 1 is a cross section illustrating components of an example semiconductor device, in accordance with some aspects of the disclosure.

### DETAILED DESCRIPTION

In the following description, for the purposes of explanation, numerous details are set forth to provide a thorough understanding of the disclosure. It will be apparent to one skilled in the art, however, that other aspects can be practiced without some details. Different examples are described herein, and while various features are ascribed to the examples, it should be appreciated that the features described with respect to one example may be incorporated with other examples as well. By the same token, however, no single feature or features of any described example should be considered essential to every example, as other examples may omit such features.

When an element is referred to herein as being "connected" or "coupled" to another element, it is to be understood that the elements can be directly connected to the other element, or have intervening elements present between the elements. In contrast, when an element is referred to as being "directly connected" or "directly coupled" to another element, it should be understood that no intervening elements are present in the "direct" connection between the elements. However, the existence of a direct connection does not exclude other connections, in which intervening elements may be present.

When an element is referred to herein as being "disposed" in some manner relative to another element (e.g., disposed on, disposed between, disposed under, disposed adjacent to, or disposed in some other relative manner), it is to be understood that the elements can be directly disposed relative to the other element (e.g., disposed directly on another element), or have intervening elements present between the elements. In contrast, when an element is referred to as being "disposed directly" relative to another element, it should be understood that no intervening elements are present in the "direct" example. However, the existence of a direct disposition does not exclude other examples in which intervening elements may be present.

Likewise, when an element is referred to herein as being a "layer", it is to be understood that the layer can be a single layer or include multiple layers. For example, a conductive layer can include multiple different conductive materials or multiple layers of different conductive materials, and a dielectric layer may comprise multiple dielectric materials or multiple layers of dielectric materials. When a layer is described as being coupled or connected to another layer, it is to be understood that the coupled or connected layers may include intervening elements present between the coupled or connected layers. In contrast, when a layer is referred to as being "directly" connected or coupled to another layer, it should be understood that no intervening elements are present between the layers. However, the existence of directly coupled or connected layers does not exclude other connections in which intervening elements may be present.

Moreover, the terms left, right, front, back, top, bottom, forward, reverse, clockwise and counterclockwise are used for purposes of explanation only and are not limited to any fixed direction or orientation. Rather, they are used merely to indicate relative locations and/or directions between various parts of an object and/or components.

Furthermore, unless otherwise indicated, all numbers used herein to express quantities, dimensions, and so forth should be understood as being modified in all instances by the term "about". In this application, the use of the singular includes the plural unless specifically stated otherwise, and use of the terms "and" and "or" means "and/or" unless otherwise indicated. Moreover, the use of the terms "including" and "having", as well as other forms, such as "includes", "included", "has", "have", and "had", should be considered non-exclusive. Also, terms such as "element" or "component" encompass both elements and components comprising one unit and elements and components that comprise more than one unit, unless specifically stated otherwise.

While some features and aspects have been described with respect to the examples, one skilled in the art will recognize that numerous modifications are possible. For example, the methods and processes described herein may be implemented using hardware components, custom integrated circuits (ICs), programmable logic, and/or any combination thereof. Further, while various methods and processes described herein may be described with respect to particular structural and/or functional components for ease of description, methods provided by various embodiments are not limited to any particular structural and/or functional architecture but instead can be implemented in any suitable hardware configuration. Similarly, while some functionality is ascribed to one or more system components, unless the context dictates otherwise, this functionality can be distributed among various other system components in accordance with the several embodiments.

Moreover, while the procedures of the methods and processes described herein are described in a particular order for ease of description, unless the context dictates otherwise, various procedures may be reordered, added, and/or omitted in accordance with various implementations. Moreover, the procedures described with respect to one method or process may be incorporated within other described methods or processes; likewise, system components described according to a particular structural architecture and/or with respect to one system may be organized in alternative structural architectures and/or incorporated within other described systems. Hence, while various examples are described with or without some features for ease of description and to illustrate aspects of those embodiments, the various components and/or features described herein with respect to a particular example can be substituted, added and/or subtracted from among other described embodiments, unless the context dictates otherwise. Consequently, although several examples are described above, it will be appreciated that the disclosure is intended to cover all modifications and equivalents within the scope of the following claims.

Referring to FIG. 1, a top view illustrating components of an example semiconductor device 100 is shown, in accordance with some aspects of the disclosure. The semiconductor device 100 can be implemented as a variety of types of semiconductor devices, such as various different types and combinations of transistor structures. For example, the semiconductor device 100 can include a non-planar (three-dimensional) GAAFET device, such as a gate all-around LDMOS device. As shown in FIG. 1, the semiconductor device 100 includes a substrate 110, a well 122, a well 124, a dummy gate 132, a gate 134, a dummy gate 136, a dummy gate 138, a source 142, a drain 144, an isolation structure 152, an isolation structure 154, an isolation structure 156, a channel 160, a nanosheet 162, a nanosheet 164, a nanosheet 166, a sacrificial layer 172, a sacrificial layer 174, a sacrificial layer 176, a trench 180, an interconnect 192, an interconnect 194, and an interconnect 196. The semiconductor device 100 generally provides a structure that is suitable for use with high operating voltages (e.g., 2.5 volts to 3.3 volts).

The channel 160 can be implemented in various suitable manners. For example, while the channel 160 is shown to include three nanosheets (the nanosheet 162, the nanosheet 164, and the nanosheet 166) in FIG. 1, the channel 160 can also include more than three nanosheets or fewer than three nanosheets in some implementations. The channel 160 can also be implemented using various alternative structures other than nanosheets such as, for example, nanowires and/or other suitable structures. Further, the gate 134 can be formed around the channel 160 in various suitable manners. For example, the gate 134 can completely surround the channel 160, or the gate 134 can partially surround the channel 160 (e.g., gaps can exist between the channel 160 and the gate 134). Moreover, layers can exist in the semiconductor device 100 between the gate 134 and the channel 160 such that the gate 134 may or may not directly contact the channel 160. Additionally, the sacrificial layer 172, the sacrificial layer 174, and the sacrificial layer 176 may be or may not be considered part of the channel 160. For example, the channel 160 can be considered a "mixed channel" or a "super lattice" structure in scenarios where the sacrificial layer 172, the sacrificial layer 174, and the sacrificial layer 176 are considered part of the channel 160 along with the nanosheet 162, the nanosheet 164, and the nanosheet 166.

The substrate 110 can be formed using silicon material (e.g., crystalline silicon) and/or other suitable materials or combinations of materials. The substrate 110 can be implemented using various fabrication technologies, such as using a silicon-on-insulator (SOI) structure, a bulk semiconductor structure, an alloy semiconductor, a compound semiconductor, germanium, and/or various other suitable materials and combinations thereof. The substrate 110 generally provides a base for forming components of the semiconductor device 100 thereon. The semiconductor device 100 can be implemented in a variety of types of circuits, inducing various types of integrated circuit (IC) chips.

The well 122 and the well 124 can be formed at least partially within the substrate 110. The well 122 and the well 124 can also be formed at least partially separate from the substrate 110, for example at least partially within various types of oxide layers and/or other insulating/dielectric layers within the semiconductor device 100. The well 122 can be relatively lightly doped using a first dopant, whereas the well 124 can be relatively lightly doped using a second dopant that is different from the first dopant. For an NLDMOS implementation of the semiconductor device 100, the first dopant can be an n-type dopant (and the well 122 can accordingly be an n-type well), and the second dopant can be a p-type dopant (and the well 124 can accordingly be a p-type well). In contrast, for a PLDMOS implementation of the semiconductor device 100, the first dopant can be a p-type dopant (and the well 122 can accordingly be a p-type well), and the second dopant can be an n-type dopant (and the well 124 can accordingly be an n-type well). Various suitable n-type dopants can be used to form the well 122 and/or the well 124, including arsenic, phosphorous, and/or other similar n-type dopants, for example. Various suitable p-type dopants can also be used to form the well 122 and/or the well 124, including boron and/or other similar p-type dopants, for example.

The gate 134 can be formed around the channel 160, as noted above. The gate 134 can be formed using various suitable metals (e.g., titanium, titanium nitride, tantalum, tantalum nitride, tantalum carbide, tungsten, tungsten nitride, tungsten silicide, etc.) to from a high-k metal gate, for example. Voltage applied at the gate 134 can control the operation and conductance of the semiconductor device 100 by controlling the operation and conductance of the channel 160. Various types of spacers can be formed at least partially around the gate 134 to electrically isolate the gate 134 and prevent charge leakage. For example, the spacers can include materials with high dielectric constants such as silicon nitride, silicon oxide, and/or other suitable materials and combinations thereof. Additionally, one or more gate oxide layers can be formed between the gate 134 and the channel 160 using suitable dielectric materials such as silicon nitride, aluminum oxide, silicon dioxide, and/or other suitable materials and combinations thereof, for example. The gate 134 generally serves as an active gate, whereas the dummy gate 132, the dummy gate 136, and the dummy gate 138 are inactive gates. The dummy gate 132, the dummy gate 136, and the dummy gate 138 can be formed around the channel 160 in a similar manner as the gate 134. The dummy gate 132, the dummy gate 136, and the dummy gate 138 can also be formed using various suitable metals, in some implementations. The dummy gate 132, the dummy gate 136, and the dummy gate 138 can also be formed using polysilicon or other similar materials in some implementations. The gate 134 can include any materials that effectively form a gate terminal of a transistor.

The source 142 and the drain 144 can each be implemented at least in part as epitaxial layers within the semiconductor device 100. For example, the source 142 and the drain 144 can be implemented using relatively highly doped epitaxial layers that are formed around the channel 160. The source 142 and the drain 144 can include any materials that effectively form a source terminal and a drain terminal of a transistor, respectively. Like the gate 134, the source 142 and the drain 144 can be formed around the channel 160 in a variety of suitable manners. The epitaxial layers used to form the source 142 and the drain 144 can be formed using various suitable materials such as, for example, silicon, gallium arsenide, and/or other suitable epitaxial materials and combinations thereof. The epitaxial layers used to form the source 142 and the drain 144 can be highly doped using suitable n-type dopants (e.g., for an NLDMOS implementation of the semiconductor device 100) or suitable p-type dopants (e.g., for a PLDMOS implementation of the semiconductor device 100), for example. The well 122 and the well 124 can be doped in accordance with a first doping concentration, the epitaxial layers used to form the source 142 and the drain 144 can be doped in accordance with a second doping concentration, and the second doping concentration can be greater than the first doping concentration. The source 142 and the drain 144 can be formed in accordance with a raised source/drain (RSD) structure having advantageous electrical properties for electrostatic discharge prevention, for example.

The isolation structure 152, the isolation structure 154, and the isolation structure 156 can be implemented as shallow trench isolation (STI) structures, for example. Accordingly, the isolation structure 152, the isolation structure 154, and the isolation structure 156 can be formed as a result of etching trenches in the semiconductor device 100. For example, after etching the trench 180, the isolation structure 154 can be formed by depositing a dielectric material at least partially within the trench 180. The dielectric material used to form the isolation structure 152, the isolation structure 154, and the isolation structure 156 can be, for example, silicon oxide, silicon nitride, and/or other suitable materials and/or combinations of materials. The isolation structure 152, the isolation structure 154, and the isolation structure 156 can generally prevent leakage of electric current between different components of the semiconductor device 100.

Additionally, as shown in FIG. 1, the trench 180 can be disposed between the gate 134 and the drain 144 and within the channel 160. The isolation structure 154 can then be disposed under the trench 180, between the gate 134 and the drain 144, and at least partially within the substrate 110 (e.g., at least partially within the well 122 and/or the well 124). As a result of this structure, a depletion region can be formed in the substrate 110 (e.g., in the well 122 and/or the well 124). The depletion region is generally an insulating region where mobile charge carriers have been diffused away and/or forced away by an electric field. Then, the ionized donor and/or acceptor impurities left in the depletion region result in a depletion of charge carriers within the depletion region, thereby limiting the amount of current that can flow through the depletion region. As shown by the arrow in FIG. 1, the current flow within the semiconductor device 100 as goes from the drain 144, under the isolation structure 154 (and through the depletion region), through the gate 134, and to the source 142. As shown in FIG. 1, the current flow path also goes close to the surface (e.g., metal surface) of the gate. As a result of this current path, the semiconductor device 100 can operate at higher operating voltages (e.g., 2.5 volts to 3.3 volts).

The nanosheet 162, the nanosheet 164, and the nanosheet 166 can be implemented in various suitable manners. For example, the nanosheet 162, the nanosheet 164, and the nanosheet 166 can consist of silicon, or the nanosheet 162, the nanosheet 164, and the nanosheet 166 can consist of silicon germanium having a first concentration of germanium, among other possibilities. Likewise, the sacrificial layer 172, the sacrificial layer 174, and the sacrificial layer 176 can be implemented in various suitable manners. For example, the sacrificial layer 172, the sacrificial layer 174, and the sacrificial layer 176 can consist of silicon germanium having a second concentration of germanium that is greater than the first concentration, among other possibilities. In some examples, the first concentration of germanium can be between 10 percent and 30 percent, whereas the second concentration of germanium is between 35 percent and 65 percent. The sacrificial layer 172, the sacrificial layer 174, and the sacrificial layer 176 can be considered "sacrificial layers" in the sense that, during some alternative semiconductor fabrication processes, they may be removed ("sacrificed") during the channel release stage of the fabrication process.

In some examples, the nanosheet 162, the nanosheet 164, and the nanosheet 166 can each have a thickness (e.g., a vertical thickness as measured in a direction between the nanosheet 162 and the nanosheet 164 from the perspective shown in FIG. 1) between 4 nanometers and 12 nanometers, whereas the sacrificial layer 172, the sacrificial layer 174, and the sacrificial layer 176 can each have a thickness (e.g., a vertical thickness as measured in a direction between the nanosheet 162 and the nanosheet 164 from the perspective shown in FIG. 1) between 8 nanometers and 17 nanometers. That is, the thickness of the sacrificial layer 172, the sacrificial layer 174, and the sacrificial layer 176 can generally be greater than the thickness of the nanosheet 162, the nanosheet 164, and the nanosheet 166. A ratio of the thickness of the sacrificial layer 172, the sacrificial layer 174, and the sacrificial layer 176 can to the thickness of the nanosheet 162, the nanosheet 164, and the nanosheet 166 can be between 1.7 and 2.3.

In order to provide a structure that is suitable under high operating voltage conditions (e.g., 2.5 volts to 3.3 volts), the length of the gate 134 (e.g., the horizontal length of the gate 134 as measured in a direction between the source 142 and the drain 144 from the perspective shown in FIG. 1) typically needs to be increased relative to some alternative structures. For example, if the length of the gate 134 does not exceed about 150 nanometers, the semiconductor device 100 may be limited to operating voltages in the range of 1.2 volts to 1.5 volts. However, if the length of the gate 134 is increased to between 190 nanometers and 310 nanometers, the semiconductor device 100 can be suitable for operating voltages in the range of 2.5 volts to 3.3 volts. In some alternative structures, sacrificial layers similar to the sacrificial layer 172, the sacrificial layer 174, and the sacrificial layer 176 may be removed during a channel release stage of the fabrication process. For example, a mask can be placed over the nanosheet 162, the nanosheet 164, and the nanosheet 166, but not over the sacrificial layer 172, the sacrificial layer 174, and the sacrificial layer 176 during the channel release stage of the fabrication process. However, when the length of the gate 134 is extended, the removal of the sacrificial layers during channel release stage can lead to deformation (an in some instances, breaking) of the nanosheets due to the stress placed on the nanosheets in subsequent processing stages.

In order to prevent this deformation of the nanosheet 162, the nanosheet 164, and the nanosheet 166 during the fabrication process that may result due to the extended length of the gate 134, the fabrication process can be altered such that the mask is placed not only over the nanosheet 162, the nanosheet 164, and the nanosheet 166, but also over the sacrificial layer 172, the sacrificial layer 174, and the sacrificial layer 176 during the channel release stage of the fabrication process. As a result, the sacrificial layer 172, the sacrificial layer 174, and the sacrificial layer 176 will not be removed as a result of etching, and will instead remain part of the semiconductor device 100, and the presence of the sacrificial layer 172, the sacrificial layer 174, and the sacrificial layer 176 can prevent the deformation of the nanosheet 162, the nanosheet 164, and the nanosheet 166 during the fabrication process. This support provided by the presence of the sacrificial layer 172, the sacrificial layer 174, and the sacrificial layer 176 can be especially important as node size continues to decrease (e.g., 2nm GAAFET nodes and below). Accordingly, the semiconductor device 100 provides a structure that can enable the use of high operating voltages in circuits produced using advanced semiconductor process technologies.

The interconnect 192, the interconnect 194, and the interconnect 196 can be implemented using various suitable structures used to form electrical connections between components of the semiconductor device 100 and/or components of a circuit (e.g., an IC) including the semiconductor device 100. For example, the interconnect 192, the interconnect 194, and the interconnect 196 can be implemented as conductive copper vias, among other possible types of interconnect structures. The interconnect 192 in particular can be used to form one or more electrical connections between the source 142 and one or more additional components of the semiconductor device 100 and/or components of a circuit including the semiconductor device 100. The interconnect 194 in particular can be used to form one or more electrical connections between the gate 134 and one or more additional components of the semiconductor device 100 and/or components of a circuit including the semiconductor device 100. The interconnect 196 in particular can be used to form one or more electrical connections between the drain 144 and one or more additional components of the semiconductor device 100 and/or components of a circuit including the semiconductor device 100.

## Claims

1. A semiconductor device, comprising:
a drain;
a source;
a channel comprising a first nanosheet and a second nanosheet;
a sacrificial layer disposed between the first nanosheet and the second nanosheet; and
a gate formed around the channel.

2. The semiconductor device of claim 1, wherein:
the first nanosheet and the second nanosheet consists of silicon; and
the sacrificial layer consists of silicon germanium.

3. The semiconductor device of claim 1 or 2, wherein:
the first nanosheet and the second nanosheet consist of silicon germanium having a first concentration of germanium;
the sacrificial layer consists of silicon germanium having a second concentration of germanium; and
the second concentration of germanium is greater than the first concentration of germanium.

4. The semiconductor device of claim 3, wherein:
the first concentration of germanium is between 10 percent and 30 percent; and
the second concentration of germanium is between 35 percent and 65 percent.

5. The semiconductor device of any one of the preceding claims, wherein:
a thickness of the sacrificial layer measured in a direction between the first nanosheet and the second nanosheet is between 8 nanometers and 17 nanometers; and
a thickness of the first nanosheet measured in the direction between the first nanosheet and the second nanosheet is between 4 nanometers and 12 nanometers; and
a thickness of the second nanosheet measured in the direction between the first nanosheet and the second nanosheet is between 4 nanometers and 12 nanometers.

6. The semiconductor device of any one of the preceding claims, wherein
a thickness of the sacrificial layer measured in a direction between the first nanosheet and the second nanosheet is greater than both a thickness of the first nanosheet measured in the direction between the first nanosheet and the second nanosheet and a thickness of the second nanosheet measured in the direction between the first nanosheet and the second nanosheet.

7. The semiconductor device of any one of the preceding claims, wherein
a length of the gate measured in a direction between the source and the drain is between 190 nanometers and 310 nanometers.

8. The semiconductor device of any one of the preceding claims, comprising
a trench disposed between the gate and the drain,
wherein in particular the semiconductor device further comprises
an isolation structure disposed under the trench, between the gate and the drain, and within a substrate of the semiconductor device.

9. A semiconductor device, comprising:
a drain;
a source;
a channel comprising a first nanosheet, a second nanosheet, and a third nanosheet;
a first sacrificial layer disposed between the first nanosheet and the second nanosheet;
a second sacrificial layer disposed between the second nanosheet and the third nanosheet; and
a gate formed around the channel.

10. The semiconductor device of claim 9, wherein:
the first nanosheet, the second nanosheet, and the third nanosheet consist of silicon; and
the sacrificial layer consists of silicon germanium.

11. The semiconductor device of claim 9 or 10, wherein
a ratio of a thickness of the first sacrificial layer measured in a direction between the first nanosheet and the second nanosheet is to a thickness of the first nanosheet measured in the direction between the first nanosheet and the second nanosheet is between 1.7 and 2.3.

12. The semiconductor device of any one of the preceding claims 9 to 11, wherein
a length of the gate measured in a direction between the source and the drain is between 190 nanometers and 310 nanometers.

13. The semiconductor device of any one of the preceding claims 9 to 12, wherein:
the first nanosheet, the second nanosheet, and the third nanosheet consist of silicon germanium having a first concentration of germanium;
the first sacrificial layer and the second sacrificial layer consist of silicon germanium having a second concentration of germanium; and
the second concentration of germanium is greater than the first concentration of germanium.

14. The semiconductor device of any one of the preceding claims 9 to 13, comprising:
a trench disposed between the gate and the drain; and
an isolation structure disposed under the trench, between the gate and the drain, and within a substrate of the semiconductor device.

15. A circuit, comprising:
a substrate; and
a semiconductor device as set forth in any one of the preceding claims.
